(19)

**Europäisches Patentamt**
**European Patent Office**
**Office européen des brevets**

(11) **EP 3 563 251 B1**

(12) **EUROPEAN PATENT SPECIFICATION**

(45) Date of publication and mention
of the grant of the patent:
**19.10.2022 Bulletin 2022/42**

(21) Application number: **17907333.3**

(22) Date of filing: **28.04.2017**

(51) International Patent Classification (IPC):
*H04S 7/00* (2006.01)    *G06F 16/65* (2019.01)
*G06F 16/683* (2019.01)    *G06F 15/76* (2006.01)
*G06N 20/00* (2019.01)    *H04R 3/00* (2006.01)
*H04S 1/00* (2006.01)    *H03G 5/16* (2006.01)
*H03G 3/30* (2006.01)

(52) Cooperative Patent Classification (CPC):
**G06F 15/76; G06F 16/65; G06F 16/683;**
**G06N 20/00; H04S 7/307;** H03G 3/3089;
H03G 5/165; H04R 3/00; H04S 1/007

(86) International application number:
**PCT/US2017/030213**

(87) International publication number:
**WO 2018/199997 (01.11.2018 Gazette 2018/44)**

(54) **AUDIO CLASSIFCATION WITH MACHINE LEARNING MODEL USING AUDIO DURATION**

AUDIOKLASSIFIZIERUNG MIT MASCHINENLERNMODELL UNTER VERWENDUNG VON
AUDIODAUER

CLASSIFICATION AUDIO AVEC MODÈLE D'APPRENTISSAGE AUTOMATIQUE UTILISANT UNE
DURÉE AUDIO

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(43) Date of publication of application:
**06.11.2019 Bulletin 2019/45**

(73) Proprietor: **Hewlett-Packard Development**
**Company, L.P.**
**Spring TX 77389 (US)**

(72) Inventors:
• **BHARITKAR, Sunil**
**Palo Alto, California 94304 (US)**
• **ATHREYA, Madhu Sudan**
**Palo Alto, California 94304 (US)**

(74) Representative: **ZBM Patents - Zea, Barlocci &**
**Markvardsen**
**Rambla Catalunya, 123**
**08008 Barcelona (ES)**

(56) References cited:
**WO-A1-2016/102737    US-A1- 2009 012 638**
**US-A1- 2016 056 787    US-A1- 2016 302 014**
**US-A1- 2017 070 817**

• **Marina Jeremic: "Music Classification by genre**
**using neural networks", , 6 January 2013**
**(2013-01-06), XP055715741, Retrieved from the**
**Internet:**
**URL:http://neuroph.sourceforge.net/tutoria**
**ls/MusicClassification/music_classificatio**
**n_by_genre_using_neural_networks.html**
**[retrieved on 2020-07-16]**

**EP 3 563 251 B1**

**Description**

Background

Electronic devices employing loudspeakers (e.g., personal electronic devices, such as cell phones) may include frequency control (e.g., bass, mid-range, and treble frequency control) to adjust audio output from the loudspeakers to improve the quality of experience (QoE) of content involving audio or speech. Audio signals may comprise different classes of audio content, such as music, voice, and movie content, for example, where each class may require different frequency control for optimizing QoE. The document "Music Classification by genre using neural networks "from Marina Jeremic and published on the Internet on page http://neuroph.sourceforge.net/tutorials/MusicClassification/music classification by genre using neural networks.html discloses methods for training a neural network that uses music songs data set. Document WO2016102737 discloses an apparatus and a method for tagging audio data. Document US 2017/070817 discloses an apparatus and a method for controlling sound, and apparatus and method for training genre recognition model. Document US2016056787 discloses an equalizer controller and a controlling method.

Summary

According to the disclosure, there is provided an audio signal classifier, a non-transitory computer-readable storage medium and a method of classifying audio signals according to independent claims 1, 5 and 6, respectively. Further embodiments are set forth in the dependent claims.

Brief Description of the Drawings

Figure 1 is a block and schematic generally illustrating an audio signal classifier, according to one example.
Figure 2 is a schematic diagram generally illustrating a machine learning model, according to one example.
Figure 3 is a block and schematic generally illustrating an audio signal classifier, according to one example.
Figure 4 is a block and schematic diagram generally illustrating an audio system including an audio signal classifier, according to one example.
Figure 5 is a table illustrating mean, $\mu$, and standard deviation, $\sigma$, for Hollywood cinematic content, according to one example.
Figure 6 is a histogram illustrating a modeled Gaussian distribution of an example of 500 audio samples of cinematic content, according to one example.
Figure 7A is a graph illustrating a distribution of YouTube video duration, according to one example.
Figure 7B is a graph illustrating a distribution of YouTube video duration for music, entertainment, comedy, and sports genres, according to one example.
Figure 8 is a histogram illustrating a modeled gamma distribution of YouTube sports and comedy content, according to one example.
Figure 9 is a histogram illustrated a modeled Gaussian distribution of broadcast sports content, according to one example.
Figure 10 is a graph illustrating mean-squared-error
Figure 11 is a flow diagram illustrating a method of classifying an audio signal as being of one of a plurality of audio signal classes, according to one example.
Figure 12 is a flow diagram illustrating a method of classifying an audio signal as being of one of a plurality of audio signal classes, according to one example.
Figure 13 is a block and schematic diagram generally illustrating a computing system for implementing an audio signal classifier, according to one example.

Detailed Description

In the following detailed description, reference is made to the accompanying drawings which form a part hereof, and in which is shown by way of illustration specific examples in which the disclosure may be practiced. It is to be understood that other examples may be utilized and structural or logical changes may be made without departing from the scope of the present disclosure. The following detailed description, therefore, is not to be taken in a limiting sense, and the scope of the present disclosure is defined by the appended claims. It is to be understood that features of the various examples described herein may be combined, in part or whole, with each other, unless specifically noted otherwise.

Electronic devices (e.g., personal electronic devices, such as cell phones) typically include loudspeakers for playing audio content. Such electronic devices may include a number of audio control presets for adjusting elements of the audio reproduced by the loudspeakers (e.g., bass, mid-range, and treble frequency presets) so as to improve the quality of experience (QoE) of audio content for a user.

Audio signals may be of a number of different classes of audio content, such as music, voice, and cinema (movie) content, for example, where each audio class may require control of different audio control presets for optimizing QoE for a user. For example, the type of presets may be different for each class of audio signals, with one class requiring three presets (e.g., bass, mid-range, and treble presets) and another class requiring four or more presets (e.g., bass-1, bass-2, mid-range, and treble presets), for instance. Also, classes of audio content using a same set of presets may require different values for each preset.

Electronic devices often include one or more sets of pre-programmed audio presets for controlling elements of audio output (e.g. bass, mid-range, and treble frequency). For example, some electronic devices enable a user to select one of three pre-programmed sets of presets, one each for music, voice and cinema content. Often, a user is not aware that the pre-programmed sets presets even exist, such that the default preset being used by the device may or may not correspond to the class of audio content being reproduced. Additionally, even if a user is aware of the pre-programmed sets of presets, the user needs to manually select the appropriate set of presets, and manually select an appropriate value for each preset of the set of presets each time different audio content is being reproduced. Such a process in inherently error prone due to a user potentially not being aware of the presets, a user forgetting to apply presets, and a user applying the wrong set of presets and/or wrong preset values to the audio content.

The present disclosure provides an automated audio signal classifier that can be employed by electronic devices to classify an audio signal as one of a plurality of types or classes of audio content (e.g., voice, music, cinema etc.). The classification of the audio signal is then used to automatically identify and apply proper audio presets to control the audio content being reproduced by the loudspeakers. Such process ensures that optimal audio presets are applied so as to provide an optimal QoE for a user.

In one example, as will be described in greater detail below, an audio signal classifier, in accordance with the present disclosure, uses features of the audio signal included in metadata of the audio signal or stream to classify the audio signal as one of a plurality of audio signal classifications or types using a trained machine learning model (e.g., a neural network). In one example, among other features, the features include a duration of the audio signal, with the trained machine learning model being trained to classify audio signals based, in part, on the duration of the audio signal.

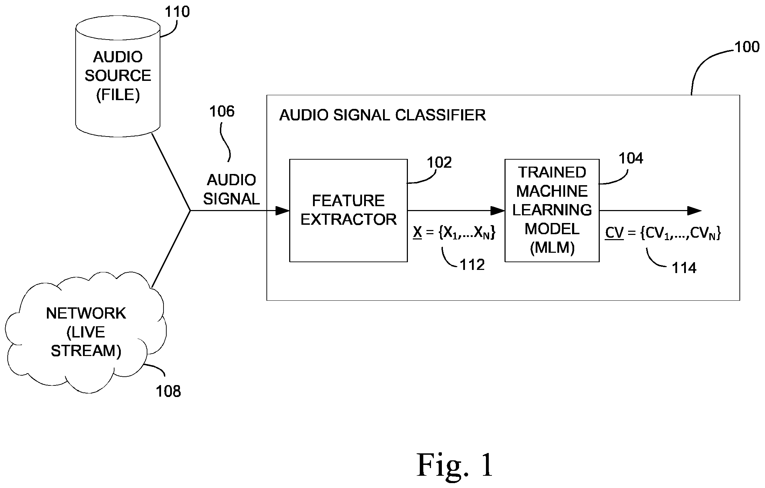

Figure 1 is a block and schematic diagram generally illustrated an audio signal classifier 100 including a feature extractor 102 and a trained machine learning model 104, according to one example. In one example, as will be describe in greater detail below, trained machine learning model 104 comprises a neural network. In Figure 1, feature extractor 102 receives a digital audio signal 106, such as in the form of streaming video from a network 108 (e.g., MPEG-2 transport stream, MPEG-4 audio-video file containers), or a file from an audio source 110, such as a database or some type of storage device, where each audio signal 106 can be classified as being one of a plurality of audio signal classes (e.g., voice, music, cinema), and where each audio signal 106 includes metadata defining parameters or features of the audio signal such as, for example, a sample rate of the audio in kHz (e.g., 16, 44.1, 48), duration of the audio signal in seconds, bit-depth in bits/sample (e.g., 16, 20, 24), file size (e.g., kilobytes), bitrate (e.g., bits/second), presence/absence of video content (video-bit 0 or 1), audio channel count (e.g., 1, 2, 6, 8), and presence object-based audio or channel-based audio (e.g., $\{0, 1\}$).

In one example, feature extractor 104 generates a feature vector, $\underline{X}$, for audio signal 106, as indicated at 112, where feature vector $\underline{X}$ includes a plurality of audio features, indicated as audio features $X_1$ to $X_N$ ($\underline{X}(=\{X_1,...,X_N\})$ selected from the metadata of audio signal 106. In one example, the selected audio features at least include the duration of the audio signals in seconds. In one instance, where metadata for audio signal 106 does not explicitly include a duration of the audio signal, feature extractor 104 generates and includes duration feature in feature vector $\underline{X}$ based on the file size and bitrate features (e.g., file size (kilobytes)/bitrate (bits/second)). The file-size information can be obtained from the file-data and duration can be computed using file-size/bitrate of the content, or can be determined by computing the difference in the beginning and end time-stamps of the file or stream. In one example, feature vector $\underline{X}$ includes six features (i.e., $\underline{X}=\{X_1, ...,X_6\}$), the six selected features being: duration of the audio signal in seconds, sample rate of the audio in kHz (e.g., 16, 44.1, 48), bit-depth in bits/sample (e.g., 16, 20, 24), presence or absence of video content (video-bit 0 or 1), audio channel count (e.g., 1, 2, 6, 8), and presence object-based audio or channel-based audio (e.g., $\{0, 1\}$).

According to one example, trained machine learning model 104 is trained to classify audio signal 106 as one of a plurality of predefined audio classes based on feature vector $\underline{X}$. In one example, trained machine learning model is trained to classify audio signal as being one of three classes of audio signals (i.e., voice, music, and cinema). In one example, as described in greater detail below, trained machine learning model 104 is trained using training or sample vectors $\underline{X}$ constructed to represent a statistical distribution of actual audio content.

In one example, trained machine learning model 104 receives feature vector $\underline{X}$, and, based on the values of features $X_1$ to $X_N$, provides a plurality of class output values $\underline{CV}$, as indicated at 114, and illustrated as $CV_1$ to $CV_X$,

(e.g., $\underline{CV}$ = {$CV_1$,...,$CV_X$}), where each class output value $CV_1$ to $CV_X$ corresponds to different one of the plurality of audio classes. According to one example, classes are substantially non-overlapping due to the choice of feature vector, but may be partially overlapping depending on whether new features are added or deleted from the feature vector set, and the output values $CV_1$ to CVx are substantially separable based on a threshold criteria. In one example, as described above, trained machine learning model 104 provides three class output values, $CV_1$ to $CV_3$, respectively corresponding to voice, music, and cinema audio classes.

According to one example, the plurality of class values $CV_1$ to CVx together are indicative of the class of the audio signal. In one example, as will be described in greater detail, the class of the audio signal, as automatically identified by audio signal classifier 100, is used to automatically identify and apply proper audio presets to control the audio content being reproduced by the loudspeakers of an audio system so as to optimize QoE for a user.

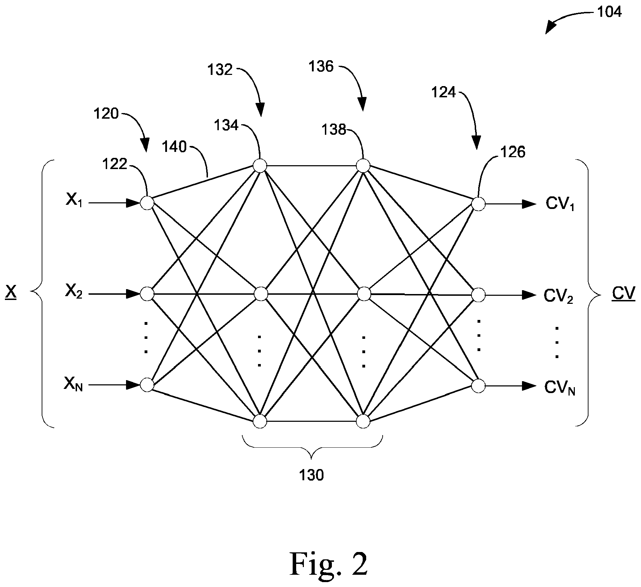

Figure 2 is a schematic diagram generally illustrating an example of machine learning model 104, where machine learning model 104 is implemented as a neural network. In one example, machine learning model 104 includes an input layer 120 including a plurality of input neurons 122, one input neuron 122 corresponding to and receiving a different one of the audio features $X_1$ to $X_N$ of feature vector $\underline{X}$, and an output layer 124 including a plurality of output neurons 124, one output neuron 124 corresponding to and providing a different one of the output class values $C_1$ to $C_N$. In one example, machine learning model 104 includes a plurality of hidden neural layers 130, such as hidden layer 132 including a number of neurons 134 and hidden layer 136 including a number of neurons 138, with hidden layers 130 interconnected by a plurality of synapses, such as synapse 140, between input and output layers 130.

In one example, machine learning model 104 includes an input layer 120 having six input neurons 122, one input neuron 122 corresponding to a different one of the six audio features of feature vector $\underline{X}$ as described above (i.e., duration, sample rate, bit-depth, presence or absence of video content, audio channel count, and presence of object-based audio or channel-based audio), an output layer 124 including three output neurons 126, one output neuron 126 corresponding to a different one of the three audio classes described above (i.e., voice, music, and cinema classes), and two hidden layers, such as hidden layers 132 and 134, where each hidden layer includes 10 hidden neurons.

In one example, machine learning model 104 includes an input layer 120 having six input neurons 122, one input neuron 122 corresponding to a different one of the six audio features of feature vector $\underline{X}$ as described above (i.e., duration, sample rate, bit-depth, presence or absence of video content, audio channel count, and presence of object-based audio or channel-based audio), an output layer 124 including three output neurons 126, one output neuron 126 corresponding to a different one of the three audio classes described above (i.e., voice, music, and cinema classes), and two hidden layers, such as hidden layers 132 and 134, where each hidden layer includes 10 hidden neurons.

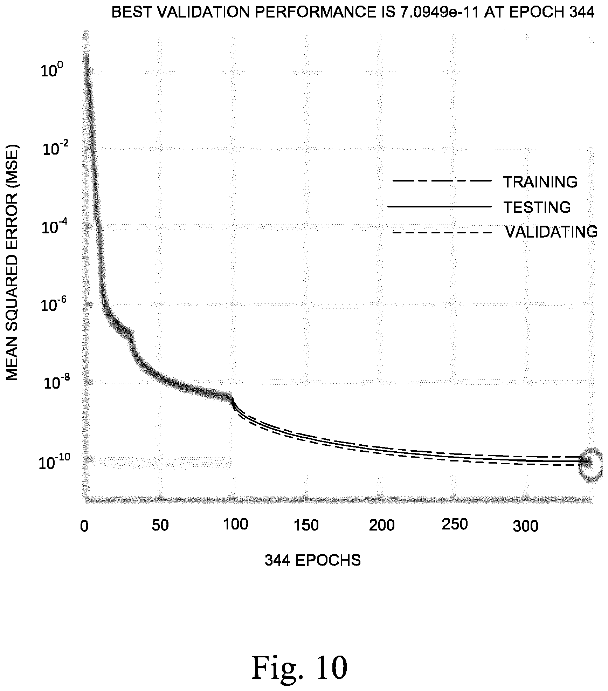

In one example, trained machine learning model 104 may employ any of a number of processing techniques such as, for example, a Bayesian Classifier, MLP with gradient descent based learning, etc. Based on the input feature vector and the corresponding associated labeled class value the output neuron produces a value. The MLP is trained on the sum-squares errors (difference between the neuron outputs and the desired output). For example if the feature-vector corresponds to movie feature set, then the output class values will be CV1=1, CV2=-1, CV3=-1 (where CV1 corresponds to the neuron or output for movie). The error is computed from the output of the three output neurons and the weights are adapted using the gradient descent algorithm. The next feature vector is delivered to the network and the error computed based on the output of the neurons and the desired class output values and the weights adapted to minimize the error. The process is repeated for all feature vectors and the feature vectors are repeatedly presented multiple times until the error is minimized (example of the error plot is shown in Fig. 10).

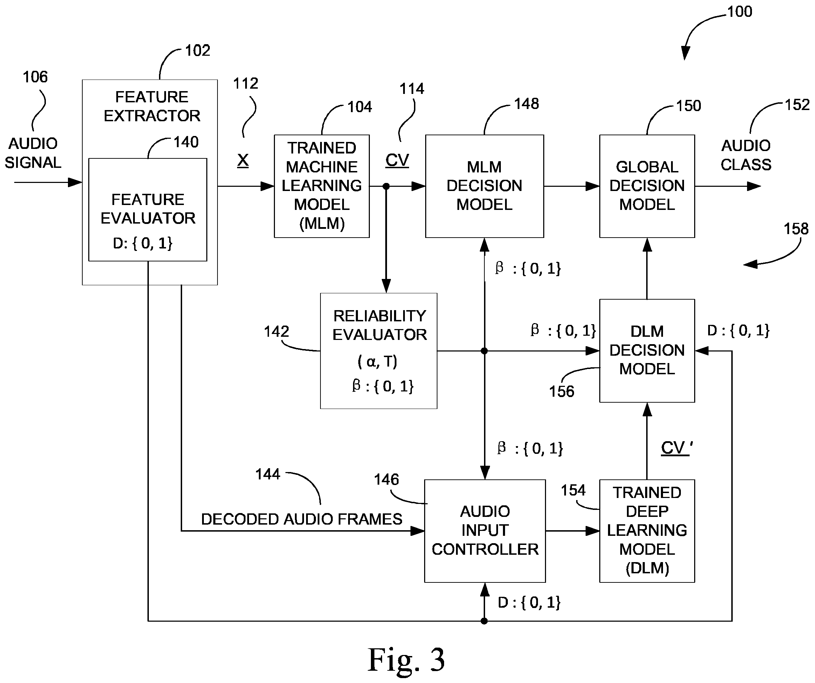

Figure 3 is a block and schematic diagram generally illustrating an example implementation of audio signal classifier 100. According to the example of Figure 3, in addition to trained machine learning model 104, audio signal classifier 100 includes a trained deep learning model 154 which is employed or "switched in" when audio signal 106 is determined by a feature evaluator 140 to have confounding or invalid metadata (e.g., metadata is missing, there is contradictory metadata, the metadata has abnormal values, etc.) or when output class values $\underline{CV}$ generated by trained machine learning model 104 are determined by a reliability evaluator 142 to be unreliable ( (i.e., the output class values do not provide a clear indication as to the class of the audio signal). With the inclusion of trained deep learning model 154, the example audio signal classifier 100 of Figure 3 may be referred as a dual-model machine learning audio signal classifier.

In contrast to trained machine learning model 104, which classifies audio signal 106 based on metadata from audio signal 106, trained deep learning model 154 classifies audio signal 106 based on decoded audio frames from audio signal 106 (e.g. time-domain frames and/or time frequency data computed using short-time Fourier transforms (STFT) over frames (e.g., 20 ms of audio data)). In one example, trained deep learning model 154 comprises a neural network employing multi-stage classifiers. In one example, trained deep learning model 154 is trained on frames of labeled audio data such as, for example, explosions, applause, Foley (i.e., reproduced sound effects), music, etc. Based on the decoded audio frames, trained deep learning model 154 outputs a plurality of output class values, $\underline{CV}'$, with each class value corresponding to a different class of the plurality of audio classes (e.g., voice, music, and cinema), and the plurality of output class values together indicating the class of audio signal 106.

Examples of the operation of audio signal classifier 100 of Figure 3 are described below. Initially, feature extractor 102 receives audio signal 106 and extracts metadata therefrom. According to one example, feature evaluator 140 evaluates the integrity or validity of the metadata (e.g. whether there is metadata missing, whether there is contradictory metadata, whether the metadata has atypical values, etc.). In one case, feature evaluator 40 generates a robustness value, D, having a value of either "0" or "1" (D:{0, 1}) based on the extracted metadata. In one example, D has a value of "0" (D=0) when the metadata is valid, and a value of "1" (D=1) when the reliability of the metadata is confounding (e.g., when there is missing metadata, corrupted metadata, contradictory metadata, or atypical metadata).

According to the example of Figure 3, feature extractor 102 provides decoded audio frames 144 to an audio input controller 146. In one example, audio input controller 146 either passes decoded audio frames 144 to trained deep learning model 154 for processing or blocks trained deep learning model 154 from receiving decoded audio frames 144, depending on robustness value, D, generated by feature evaluator 140 and on a reliability value, β, generated by reliability evaluator 142 (which will be described in greater detail below. In one example, audio input controller 146 passes decoded audio frames 144 to trained deep learning model 154 by applying a gain with a value of "1" to decoded audio frames 144, or blocks trained deep learning model 154 from receiving decoded audio frames 144 by applying a gain having a value of "0" to decoded audio frames 144.

Continuing with the operation of audio signal classifier 100, when robustness value D=0, feature extractor 102 provides feature vector $\underline{X}$ to trained machine learning model 104. In response, trained machine learning module 104 provides the plurality of output class values $\underline{CV}$ (e.g., one class value for each class of a plurality of audio classes) to reliability evaluator 142 and to a corresponding MLM (machine learning model) decision model 148. Additionally, it is noted that audio input controller 146 does not pass decoded audio frames 144 to trained deep learning model 154 in response to robustness value D being "0".

In one example, upon receiving output class values $\underline{CV}$, reliability evaluator 142 generates a reliability index, α, which is indicative of the reliability of output class values $\underline{CV}$ (i.e., how reliable or accurate will the resulting classification be based on such output class values). In one case, the reliability index, α, is based on an amount of separation between the class values $\underline{CV}$. In one example, reliability index α is the root mean square error between each of the output class values $\underline{CV}$. In one example, if the reliability index α is greater than or equal to a threshold value, T, the output class values $\underline{CV}$ are deemed to be reliable, and reliability evaluator 142 provides a reliability value, β, having a value of "1" (β=1). Conversely, if the reliability index α is less than the threshold value, T, reliability evaluator 142 provides a reliability value, β, having a value of "1" (β=0), indicating that class values $\underline{CV}$ are deemed to be unreliable.

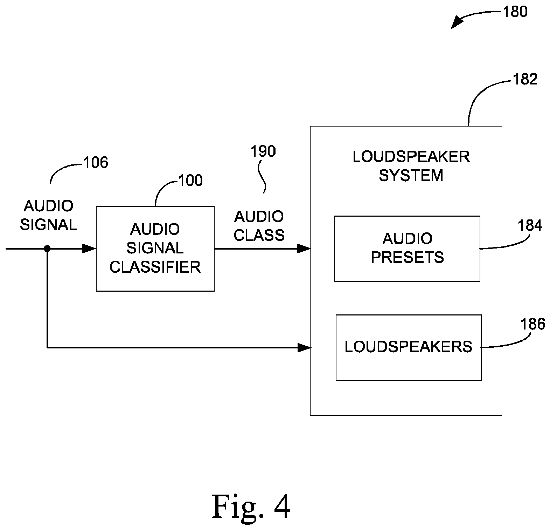

In a scenario where the β=1 (meaning that output class values $\underline{CV}$ are reliable), audio input controller 146 does not pass decoded audio frames 144 to trained deep learning model 154. Additionally, with β=1, MLM decision model 148 determines the class of audio signal 106 based on the plurality of output class values $\underline{CV}$. In one case, MLM decision model 148 classifies audio signal 106 as belonging to the audio class corresponding to the class value of the plurality of class values CV having the highest value. For example, in a case where the plurality of audio classes are {movie, music, voice} and the corresponding $\underline{CV}$ values are $\underline{CV}$={-1, +1, -1}, MLM decision model 148 will classify audio signal 106 as "music", since music has the highest corresponding class value (i.e. "+1"). According to this scenario, where β=1, MLM decision model 148 passes the determined audio class (e.g., "movie") to global decision model 150 which, in this case, acts as a "pass-thru" and provides the identified audio class received from MLM decision model 148 as output audio class 152. In one example, output audio class 152 is used to select audio presets to adjust an audio output of loudspeakers (e.g., see Figure 4 below).

In a case where the β=0 (meaning that output class values $\underline{CV}$ are not reliable), rather than determining the audio class of audio signal 106 and providing an identified audio class to global decision model 150, MLM decision model 148 instead passes the plurality of output class values $\underline{CV}$ to global decision model 150. An example of this is a case when the CV values are distributed as {0.2, -0.1, -0.7} where the separation between movie and music class values are not significant (significance being determined based on pairwise error computation between class values). Additionally, with β=0, audio input controller 146 passes decoded audio frames 144 to trained deep learning model 154. In response, trained deep learning model 154 generates and provides a plurality of output class values $\underline{CV}'$ to a DLM decision model 156 corresponding to trained deep learning model 154, where each output class value corresponds to a different class of the plurality of audio classes. With β=0, rather than determining the audio class of audio signal 106 and providing an identified audio class to global decision model 150, DLM decision model 156 passes the plurality of output class values $\underline{CV}'$ to global decision model 150.

In response to receiving the plurality of output class values $\underline{CV}$ and the plurality of output class values $\underline{CV}'$, global decision model 150 does not act as a pass-thru, but instead determines an audio class for audio signal 106 based on the two sets of output class values. Global decision model 150 may employ any number of techniques for determining an audio class for audio signal 106. In one case, global decision model 50 simply classifies audio signal 106 as belonging to the audio class corresponding the class values having the largest sum. For example, in a case where the plurality of audio classes are {movie, music, voice} and the corresponding $\underline{CV}$ values are $\underline{CV}$={0.5, 0.4, 0.1} and $\underline{CV}'$ values are $\underline{CV}'$={0.6, 0.1, 0.3}, global decision model 150 will designate audio signal 106 as a "movie" since the sum of the corresponding class values has the highest value (i.e., {movie, music, voice}= {1.1, 0.5, 0.4}).

In another example, global decision model 150 may employ a linear weighted average. For example, global decision model 150 may apply a "weight1" to the plurality of class values CV, and a "weight2" to the plurality of class values CV, such that movie=((0.5\*weight1+0.6\*weight2)/(weight1 + weight2)); music=((0.4\*weight1+0.1\*weight2)/(weight1 + weight2)); and voice=((0.1\*weight1+0.3\*weight2)/(weight1 + weight2)). If weight1=0.5 and weight2=1, then {movie, music, voice} = {0.57, 0.2, 0.23}, such that global decision model 150 will designate audio signal 106 as a "movie".

Returning to feature evaluator 140, in a scenario where robustness value, D, has a value of "1" (D=1), meaning that metadata has been deemed to be unreliable, audio input controller 146 will pass decoded audio frames 144 to trained deep learning model 154. However, since trained machine learning model 104 is not trained on unreliable metadata (i.e., unreliable feature values), feature extractor 102 does not provide feature vector $\underline{X}$ to trained deep learning model 104.

In such scenario, upon receiving decoded audio frames 144 via audio input controller 146, trained deep learning model 154 generates and provides the plurality of output class values $\underline{CV'}$ to DLM decision model 156. With D=1, DLM decision model 156 determines the class of audio signal 106 based on the plurality of output class values $\underline{CV'}$. In one case, DLM decision model 156 classifies audio signal 106 as belonging to the audio class corresponding to the class value of the plurality of class values $\underline{CV'}$ having the highest value. For example, in a case where the plurality of audio classes are {movie, music, voice} and the corresponding $\underline{CV'}$ values are $\underline{CV'}$ = {-1, +1, -1}, DLM decision model 156 will classify audio signal 106 as "music", since music has the highest corresponding class value (i.e. "+1"). DLM decision model 156 passes the determined audio class (e.g., "movie") to global decision model 150 which, in this case (D=1), acts as a "pass-thru" and provides the identified audio class received from DLM decision model 156 as output audio class 152.

In view of the above, when D=0 and β=0, audio classifier 100 of Figure 3 employs only trained machine learning model 104 to determine an audio class of audio signal 106. Conversely, when D=1, audio classifier 100 of Figure 3 employs only deep trained learning model 154 to determine an audio class of audio signal 106. Finally, when D=0 and β=1, audio classifier 100 of Figure 3 employs both trained machine learning model 104 and trained deep learning model 154 to determine an audio class of audio signal 106. In one example, MLM decision model 148, DLM decision model 156, and global decision block 150 together form and output decision model 158.

Figure 4 is a block and schematic diagram generally illustrating an audio system 180 including a loudspeaker system 182 and an audio signal classifier 100, such as described by Figures 1-3, according to one example. Loudspeaker system 182 includes a plurality of sets of audio presets, each corresponding to a different audio class, and one or more loudspeakers 186 for reproducing audio signal 106. In one example, such as described above with reference to Figures 1-3, audio classifier 100 classifies audio signal 106 as belong to one class of a plurality of audio signal classes (e.g., voice, music, cinema) and provides indication of the identified audio class 190 of audio signal 106 to loudspeaker system 182. In one example, loudspeaker system 182 selects the set of audio presets corresponding to the identified audio class to adjust the audio output of loudspeakers 186.

To employ the duration feature of an audio signal as a classifying feature, since content length can vary significantly, the duration of the audio signal is modeled. According to one example, statistical distributions are used to model duration for audio content (e.g., voice, music and cinema).

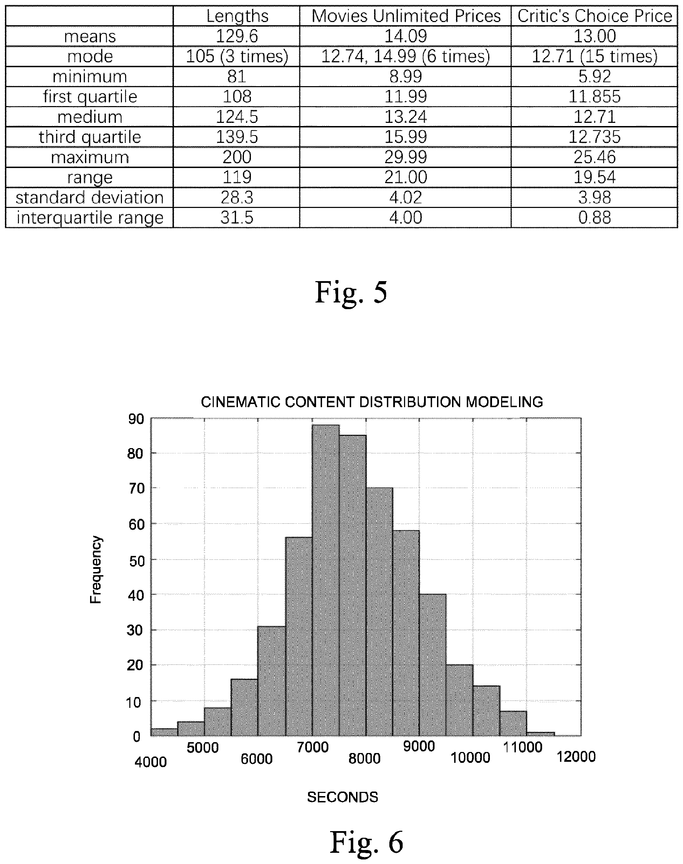

Figure 5 is a table showing publicly available information regarding mean, μ, and standard deviation, σ, for Hollywood cinematic content. Given the mean and standard deviation represent second-order statistics of normal distributions, according to one example, 500 samples of duration data for training samples were generated using the mean and standard deviation of Figure 5 and Equation I as follows:

$$\text{Equation I:} \quad f(x|\mu,\sigma) = \frac{1}{\sigma\sqrt{2\pi}}e^{\left(-\frac{(x-\mu)^2}{2\sigma^2}\right)}.$$

Figure 6 is a histogram showing a modeled Gaussian distribution of an example of 500 audio samples used for cinematic (movie) content using the distribution of Equation I above.

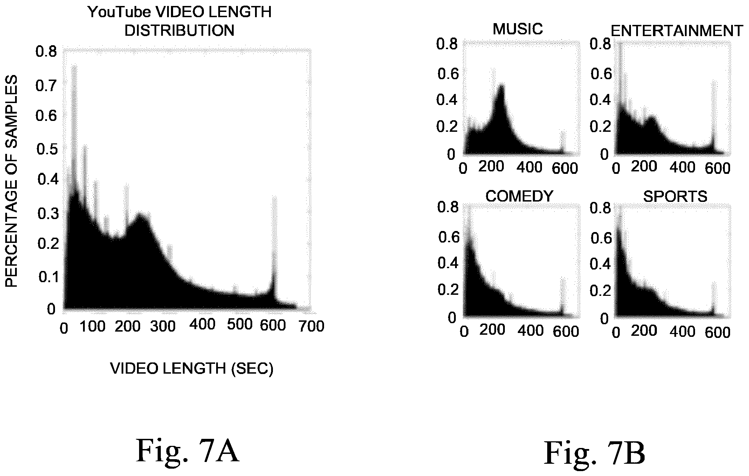

Similarly, content distributions of durations for publically available YouTube content are shown in Figure 7A. In one example, for YouTube music distribution, a Gaussian distribution with appropriate mean, μ, and standard deviation, σ, using Equation I was applies to generate 500 samples, whereas for sports and comedy distribution (labeled as "voice"), a gamma distribution according to Equation II below was used to generate 500 samples for these two classes using the gamma function Γ(α),

Equation II:
$$f(x|a,b) = \frac{1}{b^a \Gamma(a)} x^{a-1} e^{(-x/b)}.$$

Distributions for durations of YouTube content for music, entertainment, comedy, and sports, as described above, are illustrated by Figure 7B.

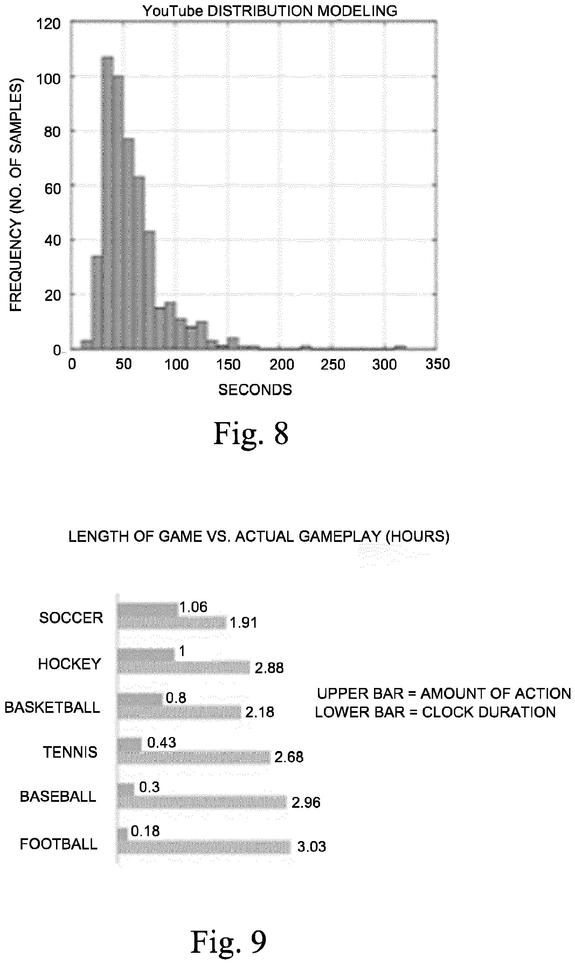

A modeled Gaussian distribution of YouTube sports broadcast content is illustrated by Figure 8, where again, appropriate mean, $\mu$, and standard deviation, $\sigma$, were employed using Equation II to generate 500 training samples for machine learning model 104.

In one example, samples generated from distribution modeling of the duration were permuted with other features of the feature vector (e.g., sample rate, bit depth, number of channels, video presence) to create 500 training feature vectors in a meaningful way based on how typical audio content is encoded an exists. In one example, the training feature vectors were randomized before applying them to machine learning model 104, with the training be done to minimize the sum-squares error (e.g., the difference between actual output of the output neuron for each class and a value labeled for a target class, either a -1 or a +1 for a hyperbolic tangent transfer function of the output neuron) over all outputs and training samples using the Levenberg-Marquart algorithm for updating the synapse weights of the machine learning model. It is noted that a sigmoid with output values $\in [0,1]$ does not change classification accuracy.

Figure 10 is a graph illustrating exemplary results of training a machine learning model 104 of audio signal classifier 100, as illustrated by Figure 2, where 6 input neurons 122 were employed, two hidden layers 132 and 134 were used, with each hidden layer using 10 neurons, and an output layer 124 having three output neurons 126 was used. Each of the 6 input neurons received a different one of six feature values ($X_1$, ...,$X_6$) of feature vector X (i.e., duration of the audio signal in seconds, sample rate of the audio in kHz (e.g., 16, 44.1, 48), bit-depth in bits/sample (e.g., 16, 20, 24), presence or absence of video content (video-bit 0 or 1), audio channel count (e.g., 1, 2, 6, 8), and presence object-based audio or channel-based audio (e.g., {0, 1})), and each of the three output neurons 126 provided a class value for a different class of three possible audio signal classes (i.e., voice, music, and cinema). In Figure 10, it is noted that the 3 curves substantially merge and overlay one another below 300 epochs.

Exemplary classification results for several actual cinematic, sports (voice), and music videos using the above-described trained machine learning model 104 are described below. For the movie "Edge of Tomorrow" having a duration of 6,780 seconds, a sample rate of 48 kHz, an audio channel count of 8, a bit-depth of 24, a video bit = 1, and an object bit =0, trained machine learning model provided class output values of +1.0 for the movie class, -0.99 for the music class, and -1.0 for the voice class. Based on maxima, the trained machine learning model 104 correctly identified the audio signal as being of the movie class.

As another example, for the movie "Batman (The Dark Knight Rises)" having a duration of 9,900 seconds, a sample rate of 48 kHz, an audio channel count of 6, a bit-depth of 24, a video bit = 1, and an object bit =0, trained machine learning model 104 provided class output values of +1.0 for the movie class, -1.0 for the music class, and -1.0 for the voice class. Based on maxima, the trained machine learning model 104 correctly identified the audio signal as being of the movie class.

As another example, for a "YouTube music video for Maroon-5" having a duration of 61 seconds, a sample rate of 44.1 kHz, an audio channel count of 2, a bit-depth of 16, a video bit = 1, and an object bit =0, trained machine learning model 104 provided class output values of -1.0 for the movie class, +1.0 for the music class, and -1.0 for the voice class. Based on maxima, the trained machine learning model 104 correctly identified the audio signal as being of the music class.

As another example, for a "YouTube sports video of a Georgia vs. North Carolina football game" having a duration of 9440 seconds, a sample rate of 44.1 kHz, an audio channel count of 2, a bit-depth of 16, a video bit = 1, and an object bit =0, the trained machine learning model 104 provided class output values of -1.0 for the movie class, -1.0 for the music class, and +1.0 for the voice class. Based on maxima, the trained machine learning model 104 correctly identified the audio signal as being of the voice class.

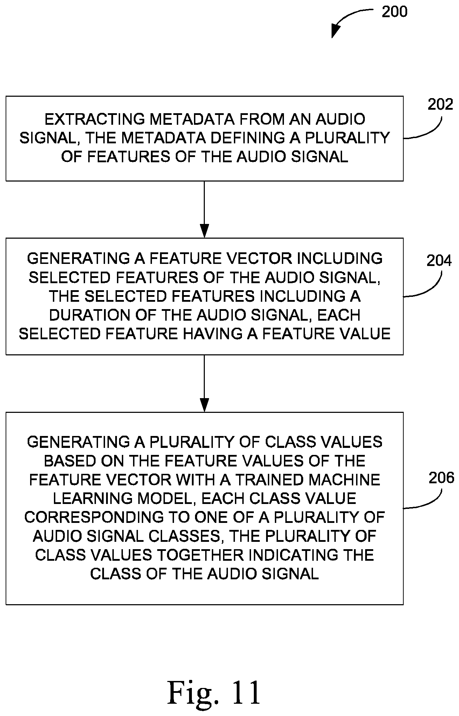

Figure 11 is a flow diagram generally illustrating a method 200 of classifying an audio signal as being of one of a plurality of audio signal classes, according to one example. At 202, metadata is extracted from an audio signal, the metadata defining a plurality of features of the audio signal, such as feature extractor 102 extracting metadata from audio signal 106 as illustrated and described by Figures 1 and 3, for example.

At 204, a feature vector is generated which includes selected features of the audio signal, the selected features including a duration of the audio signal, each selected feature having a feature value, such feature extractor 102 generating a feature vector X from metadata of audio signal 106 as illustrated and described by Figure 1 and 3, for example.

At 206, method 200 includes generating a plurality of class values based on the feature values of the feature vector using a trained machine learning model, such as trained machine learning model 104 generating output class values <u>CV</u>, as described with respect to Figures 1 and 3, where each class value corresponds to different one of a plurality of audio signal classes (e.g., voice, music, cinema), and where the plurality of class values together indicate the class of the audio signal, the class of the audio signal to select audio presets to adjust audio output of loudspeakers (see Figure 4, e.g.).

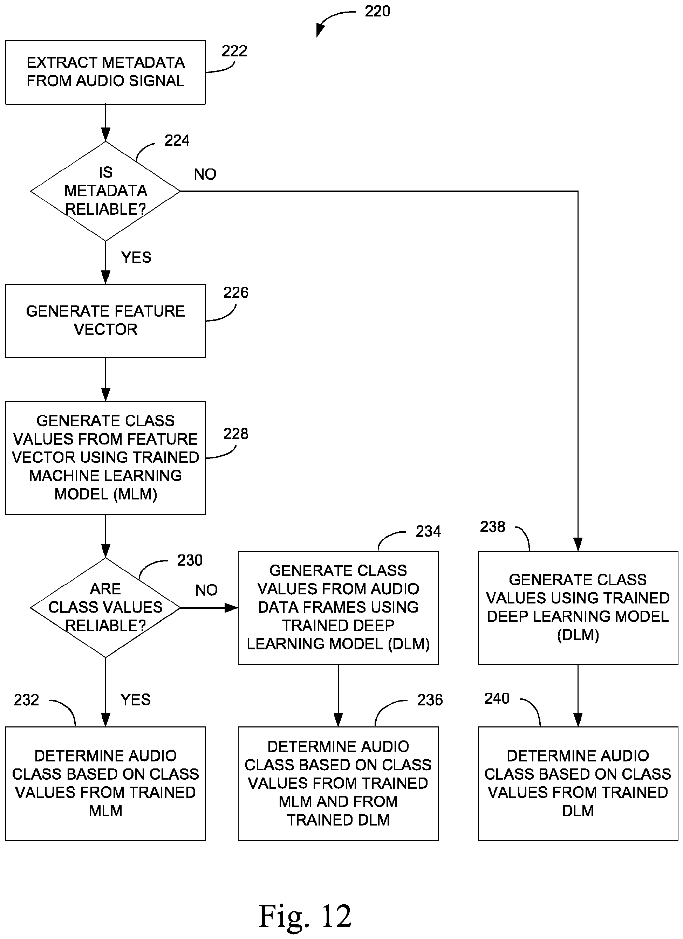

Figure 12 is a flow diagram generally illustrating a method 220 of classifying an audio signal as being of one of a plurality of audio signal classes, according to one example. At 222, metadata is extracted from an audio signal, the metadata defining a plurality of features of the audio signal, such as feature extractor 102 extracting metadata from audio signal 106, as described above with respect to Figures 1 and 3, for example.

At 224, it is queried whether the extracted metadata is reliable (e.g. the metadata is not corrupt, metadata is not missing, metadata does not have atypical values), such as feature evaluator 140 determining a robustness value, D, as illustrated above with respect to Figure 3, for example. According to one example, if the answer to the query at 224 is "yes", method 220 proceeds to 226.

At 226, a feature vector is generated from the metadata, the feature vector including selected features of the audio signal, including a duration of the audio signal, each selected feature having a feature value, such as feature extractor 102 generating feature vector $\underline{X}$ from metadata extracted from audio signal 106. In one example, in addition to a duration of the audio signal, the feature vector includes a plurality of additional features, such as a sample rate, a bit-depth, a presence or absence of video data, an audio channel count, and presence or absence of object-based audio or channel-based audio, for example.

At 228, method 220 includes employing a trained machine learning model to generate from the feature vector a plurality of output class values based on the feature values, with each output class value corresponding to one class of the plurality of audio signal classes (e.g., voice, music, cinema), such as trained machine learning model 104 of Figures 1 and 3 generating a first plurality of output class values, $\underline{CV}$. In one example, the trained machine learning model comprises a neural network, such as illustrated by Figure 2.

At 230, it is queried whether the first plurality of output class values generated by the trained machine learning model is reliable, such as reliability evaluator 142 evaluating whether the plurality of output values CV generated by trained machine learning model 104 are valid via generation of validity value, $\beta$, as illustrated and described with respect to Figure 3. In one example, if the answer to the query at 230 is "yes", meaning the class values are reliability (e.g. $\beta$ = 1), method 220 proceeds to 232.

At 232, an audio class is determined for the audio signal based on the values of the first plurality of class values generated by the trained machine learning model at 230, such as MLM decision model 148 determining an audio class to which input signal 106 belongs based on the plurality of output class values $\underline{CV}$ generated by trained machine learning model 104, as described above with respect to Figure 3, when robustness value D=0 and reliability value $\beta$=1.

Returning to 230, if the answer to the query at 230 is "no", meaning that the output class values generated by the trained machine learning model are not reliable, method 220 proceeds to 234. At 234, a trained deep learning model generates a second plurality of output class values based on audio frames extracted from the audio signal, such as trained deep learning model 154 generating a set of output class values $\underline{CV}'$ based on audio frames 144, as illustrated and described by Figure 3.

At 236, a class of the audio signal is determined from the first set of output class values generated by the trained machine learning model at 228 and on the second set of output class values generated by the trained deep learning model at 236, such as output class values $\underline{CV}$ generated by trained machine learning model 104 and output class values $\underline{CV}'$ generated by trained deep learning model 154 as illustrated by Figure 3, when robustness value D=0 and $\beta$=0.

Returning to 224, if the query as to whether the metadata is reliable is "no", method 220 proceeds to 238. At 238, a trained deep learning model generates a second plurality of output class values based on audio frames extracted from the audio signal, such as trained deep learning model 154 generating a set of output class values $\underline{CV}'$ based on audio frames 144, as illustrated and described by Figure 3.

At 240, an audio class is determined for the audio signal based on the values of the second plurality of class values generated by the trained deep learning machine learning model, such as DLM decision model 156 of Figure 3 determining an audio class to which input signal 106 belongs based on the plurality of output class values $\underline{CV}'$ generated by trained machine learning model 104, as described above with respect to Figure 3, when robustness value D=1.

In one example, audio signal classifier 100, including feature extractor 102 and trained machine learning model 104, may be implemented by a computing system. In such examples, audio signal classifier 100, including each of the feature extractor 102 and trained machine learning model 104, of the computing system may include any combination of hardware and programming to implement the functionalities of audio signal classifier 100, including global feature extractor 102 and trained machine learning model 104, as described herein in relation to any of FIGS. 1-12. For example, programming for audio signal classifier 100, including feature extractor 102 and trained machine learning model 104, may be implemented as processor executable instructions stored on at least one non-transitory machine-readable storage medium and hardware may include at least one processing resource to execute the instructions. According to such examples, the at least one non-transitory machine-readable storage medium stores instructions that, when executed by the at least one processing resource, implement audio signal classifier 100, including feature extractor 102 and trained machine learning model 104.

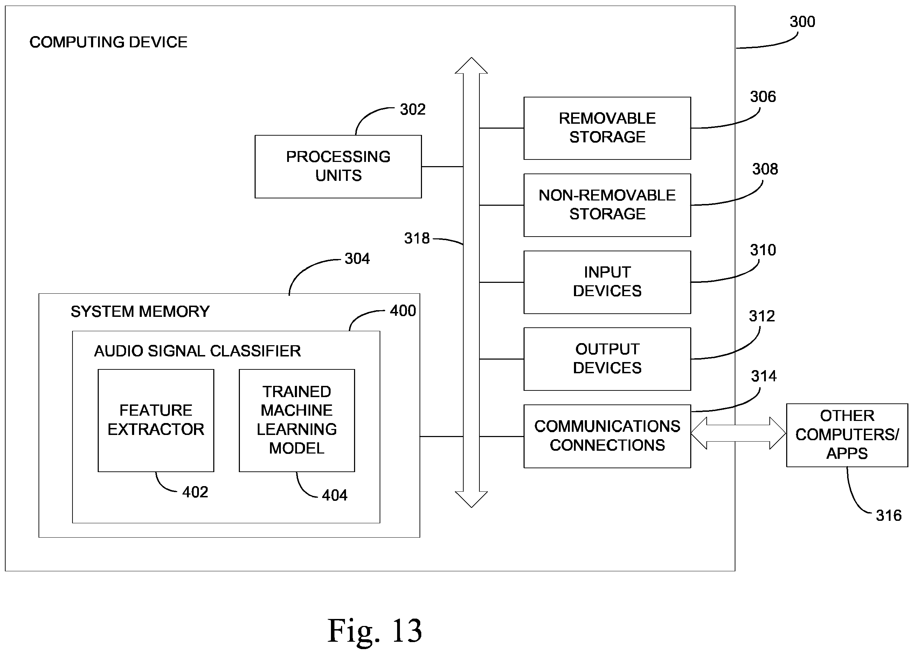

Figure 13 is a block and schematic diagram generally illustrating a computing system 300 for implementing audio signal classifier 100 according to one example. In the illustrated example, computing system or computing device 300 includes processing units 302 and system memory 304, where system memory 304 may be volatile (e.g. RAM), non-volatile (e.g. ROM, flash memory, etc.), or some combination thereof. Computing device 300 may also have additional features/functionality and additional or different hardware. For example, computing device 300 may include input devices 310 (e.g. keyboard, mouse, etc.), output devices 312 (e.g. display), and communication connections 314 that allow computing device 300 to communicate with other computers/applications 316, wherein the various elements of computing device 300 are communicatively coupled together via communication links 318.

In one example, computing device 300 may include additional storage (removable and/or non-removable) including, but not limited to, magnetic or optical disks or tape. Such additional storage is illustrated in Figure 13 as removable storage 306 and non-removable storage 308. Computer storage media includes volatile and nonvolatile, removable and non-removable media implemented in any suitable method or technology for non-transitory storage of information such as computer readable instructions, data structures, program modules, or other data, and does not include transitory storage media. Computer storage media includes RAM, ROM, EEPROM, flash memory or other memory technology, CD-ROM, digital versatile disks (DVD) or other optical storage, magnetic cassettes, magnetic tape, and magnetic disc storage or other magnetic storage devices, for example.

System memory 304, removable storage 306, and non-removable storage 308 represent examples of computer storage media, including non-transitory computer readable storage media, storing computer executable instructions that when executed by one or more processors units of processing units 302 causes the one or more processors to perform the functionality of a system, such as audio signal classifier 100. For example, as illustrated by Figure 13, system memory 304 stores computer executable instructions 400 for audio signal classifier 100, including feature extractor instructions 402 and trained machine learning model instructions 404, that when executed by one or more processing units of processing units 302 implement the functionalities of audio signal classifier 100, including feature extractor 102 and trained machine learning model 104, as described herein. In one example, one or more of the at least one machine-readable medium storing instructions for audio signal classifier 100, including feature extractor 102 and trained machine learning module 102, may be separate from but accessible to computing device 300. In other examples, hardware and programming may be divided among multiple computing devices.

In some examples, the computer executable instructions can be part of an installation package that, when installed, can be executed by at least one processing unit to implement the functionality of audio signal classifier 100. In such examples, the machine-readable storage medium may be a portable medium, such as a CD, DVD, or flash drive, for example, or a memory maintained by a server from which the installation package can be downloaded and installed. In other examples, the computer executable instructions may be part of an application, applications, or component already installed on computing device 300, including the processing resource. In such examples, the machine readable storage medium may include memory such as a hard drive, solid state drive, or the like. In other examples, the functionality of audios signal classifier 100, including feature extractor 102 and trained machine learning model 104 may be implemented in the form of electronic circuitry.

This application is intended to cover any adaptations or variations of the specific examples discussed herein. Therefore, it is intended that this disclosure be limited only by the claims.

**Claims**

1. An audio signal classifier (100) comprising:

a feature extractor (102) adapted to extract metadata from an audio signal (106) the metadata defining a plurality of features of the audio signal, the feature extractor (102) being adapted to generate a feature vector ($\underline{X}$) including selected features ($X_1, \ldots, X_N$) of the audio signal, the selected features including a duration of the audio signal, and each selected feature having a feature value; and to generate a robustness value (D) indicating whether the extracted metadata is valid or invalid, a machine learning model (104) trained to classify the audio signal as one of a plurality of audio signal classes based on the feature vector, the machine learning model being adapted to generate a plurality of class values ($\underline{CV}$) based on the feature values, each class value ($CV_1, \ldots, CV_N$) corresponding to one of the plurality of audio signal classes, the plurality of class values together indicating the class of the audio signal, the class of the audio signal being useable to select audio presets to adjust audio output of loudspeakers (186), the audio signal classifier further including:

a deep learning model (154) adapted to generate a plurality of class values ($\underline{CV'}$) based on audio frames (144) of the audio signal, the plurality of class values together indicating the class of the audio signal
a reliability evaluator (142) to generate a reliability value ($\beta$) indicating whether the plurality of class values generated by the machine learning model is reliable or unreliable;
the classifier further comprising an output decision model (158) adapted to determine a class (152) of the audio signal from:

only the plurality of class values generated by the machine learning model (104) when the robustness value indicates that the extracted metadata is valid and when the reliability value indicates that the plurality of class values generated by the machine learning model is reliable;
only the plurality of class values generated by the deep learning model (154) when the robustness value indicates that the extracted metadata is invalid; and
the plurality of class values generated by the machine learning model and the plurality of class values generated by the deep learning model when the robustness value indicates that the extracted metadata is valid and the reliability value indicates that the plurality of class values generated by the machine learning model is unreliable.

2. The audio signal classifier of claim 1, the feature vector, in addition to the duration of audio signal, including the selected features of a sample rate, a bit-depth, a presence or absence of video data, an audio channel count, and a presence or absence of object-based or channel-based audio.

3. The audio signal classifier of claim 1, the plurality of audio signal classes comprising a voice class, a music class, and a movie class.

4. The audio signal classifier of claim 1, the machine learning model comprising a neural network including:

a plurality of input neurons, each input neuron corresponding to a different one of the selected features of the feature vector; and
a plurality of output neurons, each output neuron providing a class value corresponding to a different one of the plurality of audio classes.

5. A non-transitory computer-readable storage medium comprising computer-executable instructions, executable by at least one processor to:

implement a feature extractor to:

extract metadata from an audio signal, the metadata defining a plurality of features of the audio signal; and
generate a feature vector including selected features of the audio signal, the selected features including a duration of the audio signal, each selected feature having a feature value; and
generate a robustness value indicating whether the extracted

metadata is valid or invalid;
implement a trained machine learning model, trained to classify the audio signal as one of a plurality of audio signal classes based on the feature vector, to: generate a plurality of class values based on the feature values of the feature vector, each class value corresponding to a different class of a plurality of audio signal classes, the plurality of class values together indicating the class of the audio signal, the class of the audio signal being useable to select audio presets to adjust audio output of loudspeakers;
implement a deep learning model to generate a plurality of class values based on audio data from audio frames of the audio signal, the plurality of class values together indicating the class of the audio signal;
implement a reliability evaluator to generate a reliability value indicating whether the plurality of class values generated by the machine learning model is reliable or unreliable; and
implement an output decision model to determine a class of the audio signal from:

only the plurality of class values generated by the machine learning model when the robustness value indicates that the extracted metadata is valid and when the reliability value indicates that the plurality of class values generated by the machine learning model is reliable;
only the plurality of class values generated by the deep learning model when the robustness value indicates that the extracted metadata is invalid; and
the plurality of class values generated by the machine learning model and the plurality of class values generated by the deep learning model when the robustness value indicates that the extracted metadata is valid and the reliability value indicates that the plurality of class values generated by the machine learning model is unreliable.

6. A method of classifying audio signals comprising:

extracting metadata from an audio signal, the metadata defining a plurality of features of the audio signal;
generating a feature vector including selected features of the audio signal, the selected features including a duration of the audio signal, each selected feature having a feature value; and
generating a first plurality of class values based on the feature values of the feature vector with a trained machine learning model, each class value corresponding to different class of a plurality of audio signal classes, the first plurality of class values together indicating the class of the audio signal, the class of the audio signal being useable to select audio presets to adjust audio output of loudspeakers;
generating a second plurality of class values based on audio frames of the audio signal with a deep learning model, each class value corresponding to different class of the plurality of audio signal classes, the first plurality of class values together indicating the class of the audio signal;
generating a robustness value indicating whether the extracted metadata is valid or invalid; and
generating a reliability value indicating whether the first plurality of class values is reliable or unreliable;
determining a class of the audio signal from:

only the first plurality of class values when the robustness value indicates that the extracted metadata is valid and when the reliability value indicates that the first plurality of class values is reliable;
only the second plurality of class values when the robustness value indicates that the extracted metadata is invalid; and
the first plurality of class values and the second plurality of class values when the robustness value indicates that the extracted metadata is valid and the reliability value indicates that the first plurality of class values is unreliable.

**Patentansprüche**

1. Audiosignalklassifizierer (100), der Folgendes umfasst:

einen Merkmalsextraktor (102), der dafür geeignet ist, Metadaten aus einem Audiosignal (106) zu extrahieren, wobei die Metadaten eine Vielzahl von Merkmalen des Audiosignals definieren, wobei der Merkmalsextraktor (102) dafür geeignet ist, einen Merkmalsvektor (X) einschließlich ausgewählter Merkmale ($X_1$,..., $X_N$) des Audiosignals zu erzeugen, wobei die ausgewählten Merkmale eine Dauer des Audiosignals einschließen und jedes ausgewählte Merkmal einen Merkmalswert aufweist; und einen Robustheitswert (D) zu erzeugen, der angibt, ob die extrahierten Metadaten gültig oder ungültig sind, ein Maschinenlernmodell (104), das dazu trainiert ist, das Audiosignal als eines von einer Vielzahl von Audiosignalklassen auf der Basis des Merkmalsvektors zu klassifizieren, wobei das Maschinenlernmodell dafür geeignet ist, eine Vielzahl von Klassenwerten (Class Values - CV) auf der Basis der Merkmalswerte zu erzeugen, wobei jeder Klassenwert ($CV_1$,..., $CV_N$) einer der Vielzahl von Audiosignalklassen entspricht, wobei die Vielzahl von Klassenwerten zusammen die Klasse des Audiosignals angeben, wobei die Klasse des Audiosignals dazu verwendbar ist, Audiovoreinstellungen auszuwählen, um die Audioausgabe von Lautsprechern (186) anzupassen, wobei der Audiosignalklassifizierer ferner Folgendes einschließt:

ein Deep-Learning-Modell (154), das dafür geeignet ist, eine Vielzahl von Klassenwerten (CV') auf der Basis von Audiorahmen (144) des Audiosignals zu erzeugen, wobei die Vielzahl von Klassenwerten zusammen die Klasse des Audiosignals angeben,
einen Zuverlässigkeitsauswerter (142), um einen Zuverlässigkeitswert ($\beta$) zu ergzeugen, der angibt, ob die Vielzahl von Klassenwerten, die durch das Maschinenlernmodell erzeugt werden, zuverlässig oder unzuverlässig sind;
wobei der Klassifizierer ferner ein Ausgabeentscheidungsmodell (158) umfasst, das dafür geeignet ist, eine Klasse (152) des Audiosignals aus Folgendem zu bestimmen:

nur der Vielzahl von Klassenwerten, die durch das Maschinenlernmodell (104) erzeugt werden, wenn der Robustheitswert angibt, dass die extrahierten Metadaten gültig sind, und wenn der Zuverlässigkeitswert angibt, dass die Vielzahl von Klassenwerten, die durch das Maschinenlernmodell erzeugt werden, zuverlässig sind;

nur der Vielzahl von Klassenwerten, die durch das Deep-Learning-Modell (154) erzeugt werden, wenn der Robustheitswert angibt, dass die extrahierten Metadaten ungültig sind; und

der Vielzahl von Klassenwerten, die durch das Maschinenlernmodell erzeugt werden, und der Vielzahl von Klassenwerten, die durch das Deep-Learning-Modell erzeugt werden, wenn der Robustheitswert angibt, dass die extrahierten Metadaten gültig sind, und der Zuverlässigkeitswert angibt, dass die Vielzahl von Klassenwerten, die durch das Maschinenlernmodell erzeugt werden, unzuverlässig ist.

2. Audiosignalklassifizierer nach Anspruch 1, wobei der Merkmalsvektor zusätzlich zu der Dauer eines Audiosignals, die ausgewählten Merkmale einer Abtastrate, eine Bit-Tiefe, ein Vorhandensein oder Nichtvorhandensein von Videodaten, eine Audiokanalzählung und ein Vorhandensein oder Nichtvorhandensein von objektbasiertem oder kanalbasiertem Audio einschließt.

3. Audiosignalklassifizierer nach Anspruch 1, wobei die Vielzahl von Audiosignalklassen eine Sprachklasse, eine Musikklasse und eine Filmklasse umfassen.

4. Audiosignalklassifizierer nach Anspruch 1, wobei das Maschinenlernmodell ein neuronales Netzwerk umfasst, das Folgendes einschließt:

eine Vielzahl von Eingabeneuronen, wobei jedes Eingabeneuron einem unterschiedlichen der ausgewählten Merkmale des Merkmalsvektors entspricht; und
eine Vielzahl von Ausgabeneuronen, wobei jedes Ausgabeneuron einen Klassenwert bereitstellt, der einem unterschiedlichen der Vielzahl von Audioklassen entspricht.

5. Nicht flüchtiges computerlesbares Speichermedium, das computerausführbare Anweisungen umfasst, die durch mindestens einen Prozessor für Folgendes ausführbar sind:
Implementieren eines Merkmalsextraktors für Folgendes:

Extrahieren von Metadaten aus einem Audiosignal, wobei die Metadaten eine Vielzahl von Merkmalen des Audiosignals definieren; und
Erzeugen eines Merkmalsvektors, der ausgewählte Merkmale des Audiosignals einschließt, wobei die ausgewählten Merkmale eine Dauer des Audiosignals einschließen, wobei jedes ausgewählte Merkmal einen Merkmalswert aufweist; und
Erzeugen eines Robustheitswerts, der angibt, ob die extrahierten Metadaten gültig oder ungültig sind;
Implementieren eines trainierten Maschinenlernmodells, das dazu trainiert ist, das Audiosignal als eines von einer Vielzahl von Audiosignalklassen auf der Basis des Merkmalsvektors zu klassifizieren, für Folgendes:
Erzeugen einer Vielzahl von Klassenwerten auf der Basis der Merkmalswerte des Merkmalsvektors, wobei jeder Klassenwert einer unterschiedlichen Klasse einer Vielzahl von Audiosignalklassen entspricht, wobei die Vielzahl von Klassenwerten zusammen die Klasse des Audiosignals angeben, wobei die Klasse des Audiosignals dazu verwendbar ist, Audiovoreinstellungen auszuwählen, um die Audioausgabe von Lautsprechern anzupassen;
Implementieren eines Deep-Learning-Modells, um eine Vielzahl von Klassenwerten auf der Basis von Audiodaten von Audiorahmen des Audiosignals zu erzeugen, wobei die Vielzahl von Klassenwerten zusammen die Klasse des Audiosignals angeben;
Implementieren eines Zuverlässigkeitsauswerters, um einen Zuverlässigkeitswert zu erzeugen, der angibt, ob die Vielzahl von Klassenwerten, die durch das Maschinenlernmodell erzeugt werden, zuverlässig oder unzuverlässig sind; und
Implementieren eines Ausgabeentscheidungsmodells, um eine Klasse des Audiosignals aus Folgendem zu bestimmen:

nur der Vielzahl von Klassenwerten, die durch das Maschinenlernmodell erzeugt werden, wenn der Robustheitswert angibt, dass die extrahierten Metadaten gültig sind, und wenn der Zuverlässigkeitswert angibt, dass die Vielzahl von Klassenwerten, die durch das Maschinenlernmodell erzeugt werden, zuverlässig sind;
nur der Vielzahl von Klassenwerten, die durch das Deep-Learning-Modell erzeugt werden, wenn der Robustheitswert angibt, dass die extrahierten Metadaten ungültig sind; und
der Vielzahl von Klassenwerten, die durch das Maschinenlernmodell erzeugt werden, und der Vielzahl von Klassenwerten, die durch das Deep-Learning-Modell erzeugt werden, wenn der Robustheitswert angibt, dass die extrahierten Metadaten gültig sind, und der Zuverlässigkeitswert angibt, dass die Vielzahl von Klassenwerten, die durch das Maschinenlernmodell erzeugt werden, unzuverlässig ist.

**6.** Verfahren zum Klassifizieren von Audiosignalen, das Folgendes umfasst:

Extrahieren von Metadaten aus einem Audiosignal, wobei die Metadaten eine Vielzahl von Merkmalen des Audiosignals definieren;

Erzeugen eines Merkmalsvektors, der ausgewählte Merkmale des Audiosignals einschließt, wobei die ausgewählten Merkmale eine Dauer des Audiosignals einschließen, wobei jedes ausgewählte Merkmal einen Merkmalswert aufweist; und

Erzeugen einer ersten Vielzahl von Klassenwerten auf der Basis der Merkmalswerte des Merkmalsvektors mit einem trainierten Maschinenlernmodell, wobei jeder Klassenwert einer unterschiedlichen Klasse einer Vielzahl von Audiosignalklassen entspricht, wobei die erste Vielzahl von Klassenwerten zusammen die Klasse des Audiosignals angibt, wobei die Klasse des Audiosignals dazu verwendbar ist, Audiovoreinstellungen auszuwählen, um die Audioausgabe von Lautsprechern anzupassen;

Erzeugen einer zweiten Vielzahl von Klassenwerten auf der Basis von Audiorahmen des Audiosignals mit einem Deep-Learning-Modell, wobei jeder Klassenwert einer unterschiedlichen Klasse der Vielzahl von Audiosignalklassen entspricht, wobei die erste Vielzahl von Klassenwerten zusammen die Klasse des Audiosignals angibt;

Erzeugen eines Robustheitswertes, der angibt, ob die extrahierten Metadaten gültig oder ungültig sind; und

Erzeugen eines Zuverlässigkeitswertes, der angibt, ob die erste Vielzahl von Klassenwerten zuverlässig oder unzuverlässig ist;

Bestimmen einer Klasse des Audiosignals aus Folgendem:

nur der ersten Vielzahl von Klassenwerten, wenn der Robustheitswert angibt, dass die extrahierten Metadaten gültig sind, und wenn der Zuverlässigkeitswert angibt, dass die erste Vielzahl von Klassenwerten zuverlässig ist;

nur der zweiten Vielzahl von Klassenwerten, wenn der Robustheitswert angibt, dass die extrahierten Metadaten ungültig sind; und

der ersten Vielzahl von Klassenwerten und der zweiten Vielzahl von Klassenwerten, wenn der Robustheitswert angibt, dass die extrahierten Metadaten gültig sind, und der Zuverlässigkeitswert angibt, dass die erste Vielzahl von Klassenwerten unzuverlässig ist.

## Revendications

**1.** Classificateur de signal audio (100) comprenant :

un extracteur de caractéristiques (102) adapté pour extraire des métadonnées d'un signal audio (106), les métadonnées définissant une pluralité de caractéristiques du signal audio, l'extracteur de caractéristiques (102) étant adapté pour générer un vecteur de caractéristiques $(\underline{X})$ comportant des caractéristiques sélectionnées $(X_1, ..., X_N)$ du signal audio, les caractéristiques sélectionnées comportant une durée du signal audio, et chaque caractéristique sélectionnée ayant une valeur de caractéristique ; et pour générer une valeur de robustesse $(D)$ indiquant si les métadonnées extraites sont valides ou non valides, un modèle d'apprentissage automatique (104) formé pour classer le signal audio comme l'une d'une pluralité de classes de signaux audio sur la base du vecteur de caractéristiques, le modèle d'apprentissage automatique étant adapté pour générer une pluralité de valeurs de classe $(\underline{CV})$ en fonction des valeurs de caractéristiques, chaque valeur de classe $(CV_1, ..., CV_N)$ correspondant à l'une de la pluralité de classes de signaux audio, la pluralité de valeurs de classe étant indiquant ensemble la classe du signal audio, la classe du signal audio pouvant être utilisée pour sélectionner des préréglages audio afin de régler la sortie audio de haut-parleurs (186), le classificateur de signal audio comportant en outre :

un modèle d'apprentissage en profondeur (154) adapté pour générer une pluralité de valeurs de classe $(\underline{CV'})$ sur la base des trames audio (144) du signal audio, la pluralité de valeurs de classe indiquant ensemble la classe du signal audio

un évaluateur de fiabilité (142) pour générer une valeur de fiabilité $(\beta)$ indiquant si la pluralité de valeurs de classe générées par le modèle d'apprentissage automatique est fiable ou non ;

le classificateur comprenant en outre un modèle de décision de sortie (158) adapté pour déterminer une classe (152) du signal audio à partir des éléments suivants :

uniquement la pluralité de valeurs de classe générée par le modèle d'apprentissage automatique (104) lorsque la valeur de robustesse indique que les métadonnées extraites sont valides et lorsque la valeur de fiabilité indique que la pluralité de valeurs de classe générées par le modèle d'apprentissage automatique est fiable ;

uniquement la pluralité de valeurs de classe générées par le modèle d'apprentissage en profondeur (154) lorsque la valeur de robustesse indique que les métadonnées extraites sont non valides ; et
la pluralité de valeurs de classe générées par le modèle d'apprentissage automatique et la pluralité de valeurs de classe générées par le modèle d'apprentissage en profondeur lorsque la valeur de robustesse indique que les métadonnées extraites sont valides et la valeur de fiabilité indique que la pluralité de valeurs de classe générées par le modèle d'apprentissage automatique n'est pas fiable.

2. Classificateur de signal audio selon la revendication 1, le vecteur de caractéristiques, en plus de la durée du signal audio, comportant les caractéristiques sélectionnées d'une fréquence d'échantillonnage, d'une profondeur de bits, d'une présence ou d'une absence de données vidéo, d'un nombre de canaux audio et la présence ou l'absence d'audio basé sur des objets ou des canaux.

3. Classificateur de signal audio selon la revendication 1, la pluralité de classes de signaux audio comprenant une classe de voix, une classe de musique et une classe de film.

4. Classificateur de signal audio selon la revendication 1, le modèle d'apprentissage automatique comprenant un réseau neuronal comportant :

une pluralité de neurones d'entrée, chaque neurone d'entrée correspondant à une caractéristique différente des caractéristiques sélectionnées du vecteur de caractéristiques ; et
une pluralité de neurones de sortie, chaque neurone de sortie fournissant une valeur de classe correspondant à une classe différente de la pluralité de classes audio.

5. Support de stockage non transitoire lisible par ordinateur comprenant des instructions exécutables par ordinateur, exécutables par au moins un processeur pour :

mettre en œuvre un extracteur de caractéristiques pour :

extraire des métadonnées d'un signal audio, les métadonnées définissant une pluralité de caractéristiques du signal audio ; et
générer un vecteur de caractéristiques comportant des caractéristiques sélectionnées du signal audio, les caractéristiques sélectionnées comportant une durée du signal audio, chaque caractéristique sélectionnée ayant une valeur de caractéristique ; et
générer une valeur de robustesse indiquant si les métadonnées extraites sont valides ou non valides ;

mettre en œuvre un modèle d'apprentissage automatique formé, qui est formé pour classer le signal audio comme l'une d'une pluralité de classes de signaux audio en fonction du vecteur de caractéristiques, pour :
générer une pluralité de valeurs de classe en fonction des valeurs de caractéristiques du vecteur de caractéristiques, chaque valeur de classe correspondant à une classe différente d'une pluralité de classes de signaux audio, la pluralité de valeurs de classe indiquant ensemble la classe du signal audio, la classe du signal audio pouvant être utilisée pour sélectionner des préréglages audio afin de régler la sortie audio de haut-parleurs ;
mettre en œuvre un modèle d'apprentissage en profondeur pour générer une pluralité de valeurs de classe sur la base de données audio à partir de trames audio du signal audio, la pluralité de valeurs de classe indiquant ensemble la classe du signal audio ;
mettre en œuvre un évaluateur de fiabilité pour générer une valeur de fiabilité indiquant si la pluralité de valeurs de classe générées par le modèle d'apprentissage automatique est fiable ou non ; et
mettre en œuvre un modèle de décision de sortie pour déterminer une classe du signal audio à partir des éléments suivants :

uniquement la pluralité de valeurs de classe générées par le modèle d'apprentissage automatique lorsque la valeur de robustesse indique que les métadonnées extraites sont valides et lorsque la valeur de fiabilité indique que la pluralité de valeurs de classe générées par le modèle d'apprentissage automatique est fiable ;
uniquement la pluralité de valeurs de classe générées par le modèle d'apprentissage en profondeur lorsque la valeur de robustesse indique que les métadonnées extraites sont non valides ; et
la pluralité de valeurs de classe générées par le modèle d'apprentissage automatique et la pluralité de valeurs de classe générées par le modèle d'apprentissage en profondeur lorsque la valeur de robustesse indique que les métadonnées extraites sont valides et la valeur de fiabilité indique que la pluralité de valeurs de classe générées par le modèle d'apprentissage automatique n'est pas fiable.

**6.** Procédé de classification de signaux audio comprenant :

l'extraction des métadonnées d'un signal audio, les métadonnées définissant une pluralité de caractéristiques du signal audio ;

la génération d'un vecteur de caractéristiques comportant des caractéristiques sélectionnées du signal audio, les caractéristiques sélectionnées comportant une durée du signal audio, chaque caractéristique sélectionnée ayant une valeur de caractéristique ; et

la génération d'une première pluralité de valeurs de classe sur la base des valeurs de caractéristiques du vecteur de caractéristiques avec un modèle d'apprentissage automatique formé, chaque valeur de classe correspondant à une classe différente d'une pluralité de classes de signaux audio, la première pluralité de valeurs de classe indiquant ensemble la classe du signal audio, la classe du signal audio pouvant être utilisée pour sélectionner des préréglages audio afin de régler la sortie audio de haut-parleurs ;

la génération d'une seconde pluralité de valeurs de classe sur la base des trames audio du signal audio avec un modèle d'apprentissage en profondeur, chaque valeur de classe correspondant à une classe différente de la pluralité de classes de signaux audio, la première pluralité de valeurs de classe indiquant ensemble la classe du signal audio ;

la génération d'une valeur de robustesse indiquant si les métadonnées extraites sont valides ou non valides ; et

la génération d'une valeur de fiabilité indiquant si la première pluralité de valeurs de classe est fiable ou non fiable ;

la détermination d'une classe du signal audio à partir des éléments suivants :

uniquement la première pluralité de valeurs de classe lorsque la valeur de robustesse indique que les métadonnées extraites sont valides et lorsque la valeur de fiabilité indique que la première pluralité de valeurs de classe est fiable ;

uniquement la seconde pluralité de valeurs de classe lorsque la valeur de robustesse indique que les métadonnées extraites sont non valides ; et

la première pluralité de valeurs de classe et la seconde pluralité de valeurs de classe lorsque la valeur de robustesse indique que les métadonnées extraites sont valides et la valeur de fiabilité indique que la première pluralité de valeurs de classe n'est pas fiable.

AUDIO SOURCE (FILE) 110

106
AUDIO SIGNAL

108
NETWORK (LIVE STREAM)

100
AUDIO SIGNAL CLASSIFIER

102
FEATURE EXTRACTOR

$\underline{X} = \{X_1, \ldots X_N\}$ 112

104
TRAINED MACHINE LEARNING MODEL (MLM)

$\underline{CV} = \{CV_1, \ldots, CV_N\}$ 114

Fig. 1

Fig. 2

Fig. 3

180

182

106

190

LOUDSPEAKER
SYSTEM

100

AUDIO
SIGNAL

AUDIO
CLASS

AUDIO
SIGNAL
CLASSIFIER

AUDIO
PRESETS

184

LOUDSPEAKERS

186

Fig. 4

| | Lengths | Movies Unlimited Prices | Critic's Choice Price |
|---|---|---|---|
| means | 129.6 | 14.09 | 13.00 |
| mode | 105 (3 times) | 12.74, 14.99 (6 times) | 12.71 (15 times) |
| minimum | 81 | 8.99 | 5.92 |
| first quartile | 108 | 11.99 | 11.855 |
| medium | 124.5 | 13.24 | 12.71 |
| third quartile | 139.5 | 15.99 | 12.735 |
| maximum | 200 | 29.99 | 25.46 |
| range | 119 | 21.00 | 19.54 |
| standard deviation | 28.3 | 4.02 | 3.98 |
| interquartile range | 31.5 | 4.00 | 0.88 |

# Fig. 5

CINEMATIC CONTENT DISTRIBUTION MODELING

# Fig. 6

Fig. 7A

Fig. 7B

EP 3 563 251 B1

YouTube DISTRIBUTION MODELING

Fig. 8

LENGTH OF GAME VS. ACTUAL GAMEPLAY (HOURS)

UPPER BAR = AMOUNT OF ACTION
LOWER BAR = CLOCK DURATION

Fig. 9

Fig. 10

200

EXTRACTING METADATA FROM AN AUDIO
SIGNAL, THE METADATA DEFINING A PLURALITY
OF FEATURES OF THE AUDIO SIGNAL

202

GENERATING A FEATURE VECTOR INCLUDING
SELECTED FEATURES OF THE AUDIO SIGNAL,
THE SELECTED FEATURES INCLUDING A
DURATION OF THE AUDIO SIGNAL, EACH
SELECTED FEATURE HAVING A FEATURE VALUE

204

GENERATING A PLURALITY OF CLASS VALUES
BASED ON THE FEATURE VALUES OF THE
FEATURE VECTOR WITH A TRAINED MACHINE
LEARNING MODEL, EACH CLASS VALUE
CORRESPONDING TO ONE OF A PLURALITY OF
AUDIO SIGNAL CLASSES, THE PLURALITY OF
CLASS VALUES TOGETHER INDICATING THE
CLASS OF THE AUDIO SIGNAL

206

Fig. 11

220

EXTRACT METADATA
FROM AUDIO SIGNAL — 222

↓

224

IS
METADATA
RELIABLE? ——————NO————————————————————┐

YES

↓

GENERATE FEATURE
VECTOR — 226

↓

GENERATE CLASS
VALUES FROM FEATURE
VECTOR USING TRAINED
MACHINE LEARNING
MODEL (MLM) — 228

↓

230

ARE
CLASS VALUES ——NO——→ GENERATE CLASS
RELIABLE? VALUES FROM AUDIO — 234
DATA FRAMES USING
TRAINED DEEP
LEARNING MODEL (DLM)

232 YES

↓

DETERMINE AUDIO
CLASS BASED ON CLASS
VALUES FROM TRAINED
MLM

GENERATE CLASS
VALUES USING TRAINED
DEEP LEARNING MODEL
(DLM) — 238

↓ 236

DETERMINE AUDIO
CLASS BASED ON CLASS
VALUES FROM TRAINED
MLM AND FROM
TRAINED DLM

240

DETERMINE AUDIO
CLASS BASED ON CLASS
VALUES FROM TRAINED
DLM

Fig. 12

Fig. 13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016102737 A
- US 2017070817 A
- US 2016056787 A